# EUROPEAN PATENT APPLICATION

(11) **EP 4 694 309 A1**
(43) Date of publication of application: **11.02.2026**
(21) Application number: 23929258.4
(22) Date of filing: 29.03.2023
(51) Int. Cl.: H04W 28/06

(54) **DATA TRANSMISSION METHOD, COMMUNICATION APPARATUS, AND COMMUNICATION SYSTEM**

(71) Applicant: Huawei Technologies Co., Ltd., Shenzhen, Guangdong 518129 (CN)
(72) Inventor: DONG, Lei, Shenzhen, Guangdong 518129 (CN); TANG, Hao, Shenzhen, Guangdong 518129 (CN); ZHANG, Liqing, Shenzhen, Guangdong 518129 (CN); MA, Jianglei, Shenzhen, Guangdong 518129 (CN)
(74) Representative: Pfenning, Meinig & Partner mbB
(86) International application number: PCT/CN2023/084824
(87) International publication number: WO 2024/197659

(57) **Abstract**

Embodiments of this application provide a data transmission method, a communication apparatus, and a communication system. The method includes: determining compressed data based on N data blocks corresponding to an AI model, where a compression scheme corresponding to each of the N data blocks is related to a distribution feature of the data block, the compressed data includes M compressed blocks, the M compressed blocks are in one-to-one correspondence with M data blocks in the N data blocks, N is an integer greater than 1, and M is an integer not greater than N; and sending the compressed data to a second apparatus. According to the solutions, the compression scheme corresponding to each data block is determined based on the distribution features of the N data blocks corresponding to the AI model, so that most matching compression schemes can be selected for different data blocks, instead of selecting a same compression scheme for all the data blocks. This helps improve compression effect of the AI model, to reduce transmission resources used for transmission of a compressed data block.

## Description

### TECHNICAL FIELD

This application relates to the field of communication technologies, and in particular, to a data transmission method, a communication apparatus, and a communication system.

### BACKGROUND

Based on an application scenario of an artificial intelligence (artificial intelligence, AI) technology, a scale of an AI model may be very large. For a large-scale AI model, an order of magnitude of data of the AI model may reach a million level or even a ten-million level. When the data of the AI model needs to be exchanged between different devices, extremely high transmission resource overheads are caused.

In a case of increasingly strained transmission resources, how to transmit data of an ultra-large-scale AI model has become a key problem to be urgently resolved in the AI field.

### SUMMARY

This application provides a data transmission method, a communication apparatus, and a communication system, to reduce resources needed for transmission of data of an AI model.

According to a first aspect, an embodiment of this application provides a data transmission method. The method is performed by a first apparatus. The first apparatus may be a terminal device, a network device, or another device, or may be an apparatus, a module, or the like that is used in cooperation with the foregoing device. The method includes: determining compressed data based on N data blocks corresponding to an AI model, where a compression scheme corresponding to each of the N data blocks is related to a distribution feature of the data block, the compressed data includes M compressed blocks, the M compressed blocks are in one-to-one correspondence with M data blocks in the N data blocks, N is an integer greater than 1, and M is an integer not greater than N; and outputting the compressed data.

In an implementation, outputting the compressed data includes sending the compressed data to a second apparatus.

In the foregoing solution, the compression scheme corresponding to each data block is determined based on the distribution features of the N data blocks corresponding to the AI model, so that most matching compression schemes can be selected for different data blocks, instead of selecting a same compression scheme for all the data blocks. This helps improve compression effect of the AI model, to reduce transmission resources used for transmission of a compressed data block.

In a possible implementation method, the M compressed blocks include at least one first data block, the first data block is a data block in the N data blocks, and an importance degree of the first data block is greater than a first threshold.

In the foregoing solution, a data block with a high importance degree is not compressed and is directly transmitted, so that it can be ensured that a loss of an information amount is not caused to the data of high importance due to compression.

In a possible implementation method, the N data blocks include at least one second data block, and the second data block does not correspond to the M compressed blocks.

In a possible implementation method, the second data block is weight data, and a change degree of the second data block is lower than a second threshold. Alternatively, the second data block is gradient data, and a probability that the second data block is within a stable interval is greater than a third threshold.

In the foregoing solution, the first apparatus does not transmit, to the second apparatus, the weight data whose change degree is lower than the second threshold or the gradient data whose probability of being within the stable interval is greater than the third threshold, so that resource occupation can be reduced and resource utilization can be improved.

In a possible implementation method, the method further includes: sending a compression parameter to the second apparatus, where the compression parameter indicates one or more of the following information: a model parameter of the AI model, a compression granularity of each of the N data blocks, or a compression scheme corresponding to each of the N data blocks; and the model parameter includes at least one of the following: a type of the AI model, a quantity of layers of the AI model, a quantity of nodes at each layer of the AI model, or a function of each layer of the AI model.

In the foregoing solution, the compression parameter is sent to the second apparatus. This helps the second apparatus correctly and quickly determine the AI model.

In a possible implementation method, the compression granularity of each of the N data blocks is a part of nodes at a layer, one layer, or a plurality of layers of the AI model.

In the foregoing solution, data that needs to be transmitted in the AI model can be flexibly mapped to the N data blocks. This helps improve transmission efficiency.

In a possible implementation method, the M data blocks include at least one third data block, the third data block includes one sub-data block or a plurality of sub-data blocks, and a difference degree between distribution information of any two of a plurality of the sub-data blocks is less than a fourth threshold.

In the foregoing solution, a data block can be accurately determined. This helps improve compression effect of the AI model, to reduce transmission resources used for transmitting a compressed data block.

According to a second aspect, an embodiment of this application provides a data transmission method. The method is performed by a second apparatus. The second apparatus may be a terminal device, a network device, or another device, or may be an apparatus, a module, or the like that is used in cooperation with the foregoing device. The method includes: receiving compressed data from a first apparatus, where the compressed data includes M compressed blocks, the M compressed blocks are in one-to-one correspondence with M data blocks in N data blocks corresponding to an artificial intelligence AI model, a compression scheme corresponding to each of the N data blocks is related to a distribution feature of the data block, N is an integer greater than 1, and M is an integer not greater than N; and determining the AI model based on the compressed data.

In the foregoing solution, the compression scheme corresponding to each data block is determined based on the distribution features of the N data blocks corresponding to the AI model, so that most matching compression schemes can be selected for different data blocks, instead of selecting a same compression scheme for all the data blocks. This helps improve compression effect of the AI model, to reduce transmission resources used for transmission of a compressed data block.

In a possible implementation method, the M compressed blocks include at least one first data block, the first data block is a data block in the N data blocks, and an importance degree of the first data block is greater than a first threshold.

In the foregoing solution, a data block with a high importance degree is not compressed and is directly transmitted, so that it can be ensured that a loss of an information amount is not caused to the data of high importance due to compression.

In a possible implementation method, the N data blocks include at least one second data block, and the second data block does not correspond to the M compressed blocks.

In a possible implementation method, the second data block is weight data, and a change degree of the second data block is lower than a second threshold. Alternatively, the second data block is gradient data, and a probability that the second data block is within a stable interval is greater than a third threshold.

In the foregoing solution, the first apparatus does not transmit, to the second apparatus, the weight data whose change degree is lower than the second threshold or the gradient data whose probability of being within the stable interval is greater than the third threshold, so that resource occupation can be reduced and resource utilization can be improved.

In a possible implementation method, the method further includes: receiving a compression parameter from the first apparatus; and determining the AI model based on the compressed data includes: determining the AI model based on the compressed data and the compression parameter, where the compression parameter indicates one or more of the following information: a model parameter of the AI model, a compression granularity of each of the N data blocks, or a compression scheme corresponding to each of the N data blocks; and the model parameter includes at least one of the following: a type of the AI model, a quantity of layers of the AI model, a quantity of nodes at each layer of the AI model, or a function of each layer of the AI model.

In the foregoing solution, the compression parameter is received from the first apparatus. This helps the second apparatus correctly and quickly determine the AI model.

In a possible implementation method, the compression granularity of each of the N data blocks is a part of nodes at a layer, one layer, or a plurality of layers of the AI model.

In the foregoing solution, data that needs to be transmitted in the AI model can be flexibly mapped to the M data blocks. This helps improve transmission efficiency.

In a possible implementation method, the M data blocks include at least one third data block, the third data block includes one sub-data block or a plurality of sub-data blocks, and a difference degree between distribution information of any two of the plurality of the sub-data blocks is less than a fourth threshold.

In the foregoing solution, a data block can be accurately determined. This helps improve compression effect of the AI model, to reduce transmission resources used for transmitting a compressed data block.

According to a third aspect, an embodiment of this application provides a communication apparatus. The apparatus has a function of implementing any one of the implementation methods of the first aspect and the second aspect. The function may be implemented by hardware, or may be implemented by hardware executing corresponding software. The hardware or the software includes one or more modules corresponding to the function.

According to a fourth aspect, an embodiment of this application provides a communication apparatus, including a unit or a means (means) used to perform steps of any one of the implementation methods of the first aspect and the second aspect.

According to a fifth aspect, an embodiment of this application provides a communication apparatus, including at least one processor. The processor is configured to perform any one of the implementation methods of the first aspect and the second aspect in at least one of the following manners: running computer instructions or a program or using a logic circuit.

In a possible implementation, the processor is coupled to a memory, and the memory stores the foregoing computer instructions or program; or the memory stores a configuration file of the logic circuit. Optionally, the memory may be located inside the apparatus, that is, the apparatus includes the memory. Optionally, the processor and the memory are integrated together. Optionally, the memory may alternatively be located outside the apparatus.

In a possible implementation, the communication apparatus further includes an interface circuit, and the interface circuit is configured to input and/or output a signal. The processor is configured to communicate with another apparatus through the interface circuit.

In a possible implementation, the communication apparatus is a chip.

According to a sixth aspect, an embodiment of this application further provides a computer program product. The computer program product includes a computer program or instructions. When the computer program or the instructions are run by a communication apparatus, any one of the implementation methods of the first aspect and the second aspect is performed.

According to a seventh aspect, an embodiment of this application further provides a computer-readable storage medium. The computer-readable storage medium stores instructions, and when the instructions are run on a communication apparatus, any one of the implementation methods of the first aspect and the second aspect is performed.

According to an eighth aspect, an embodiment of this application further provides a chip system, including a processor, configured to perform any one of the implementation methods of the first aspect and the second aspect.

According to a ninth aspect, an embodiment of this application further provides a communication system, including a first apparatus configured to perform any one of the implementation methods of the first aspect, and a second apparatus configured to perform any one of the implementation methods of the second aspect.

### BRIEF DESCRIPTION OF DRAWINGS

FIG. 1(a) is a diagram of a possible non-limiting system to which an embodiment of this application is applicable;
FIG. 1(b) is a diagram of an architecture of a communication system to which an embodiment of this application is applied;
FIG. 2 is a schematic flowchart of a data transmission method according to an embodiment of this application;
FIG. 3(a) is an example diagram of an association between a data block and a compressed block according to an embodiment of this application;
FIG. 3(b) is an example diagram of a quantization manner according to an embodiment of this application;
FIG. 4 is an example diagram of an AI model according to an embodiment of this application;
FIG. 5 is an example diagram of a method for determining a stable layer according to an embodiment of this application;
FIG. 6 is an example diagram of transmitted data according to an embodiment of this application;
FIG. 7 is a diagram of a structure of a communication apparatus according to an embodiment of this application; and
FIG. 8 is a diagram of a structure of a communication apparatus according to an embodiment of this application.

### DESCRIPTION OF EMBODIMENTS

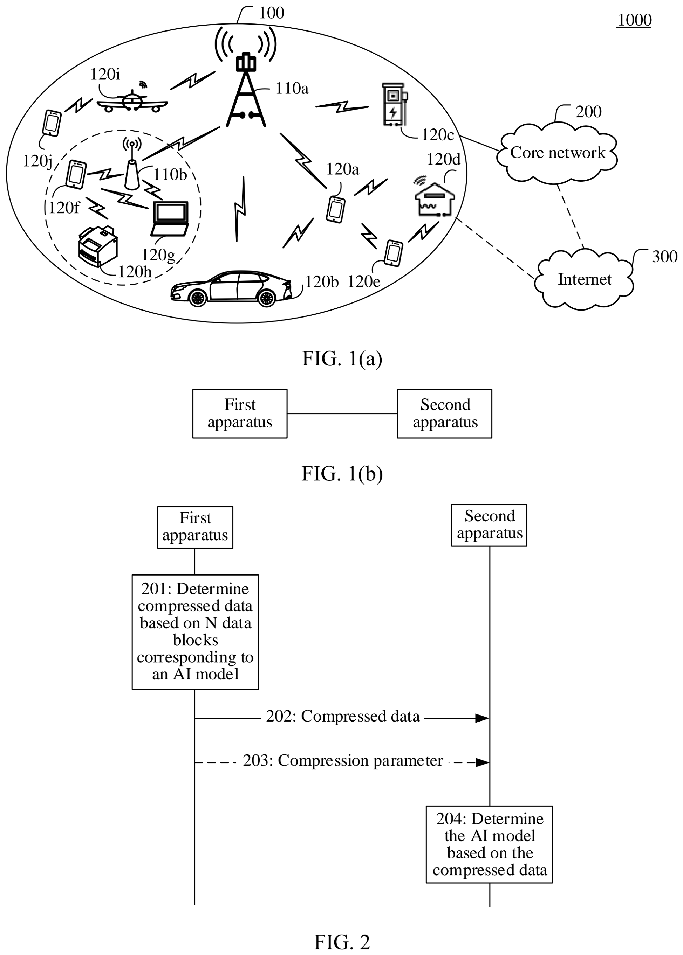

For ease of understanding of embodiments of this application, an application scenario applied to this application is described by using an architecture of a communication system shown in FIG. 1(a) as an example. FIG. 1(a) is a diagram of a possible non-limiting system. As shown in FIG. 1(a), the communication system 1000 includes a radio access network (radio access network, RAN) 100 and a core network (core network, CN) 200. The RAN 100 includes at least one network device (for example, 101a and 101b shown in FIG. 1(a), which are collectively referred to as 110) and at least one terminal device (for example, 102a to 102j shown in FIG. 1(a), which are collectively referred to as 102). The RAN 100 may further include another RAN node, for example, a wireless relay device and/or a wireless backhaul device (not shown in FIG. 1(a)). The terminal device 102 is connected to the network device 101 in a wireless manner. The network device 101 is connected to the core network 200 in a wireless or wired manner. A core network device in the core network 200 and the network device 101 in the RAN 100 may be different physical devices, or may be a same physical device that integrates a logical function of the core network and a logical function of the radio access network.

The RAN 100 may be a cellular system related to the 3rd generation partnership project (3rd generation partnership project, 3GPP), for example, a 4th generation (4th generation, 4G) or 5th generation (5th generation, 5G) mobile communication system, or an evolved system (for example, a 6th generation (6th generation, 6G) mobile communication system) after 5G. Alternatively, the RAN 100 may be an open access network (open RAN, O-RAN, or ORAN), a cloud radio access network (cloud radio access network, CRAN), or a wireless fidelity (wireless fidelity, Wi-Fi) system. Alternatively, the RAN 100 may be a communication system that integrates the foregoing two or more systems.

An apparatus provided in embodiments of this application may be used in the network device 101 or the terminal device 102. It may be understood that FIG. 1(a) shows only a possible communication system architecture to which this embodiment of this application may be applied. In another possible scenario, the communication system architecture may alternatively include another device.

FIG. 1(b) is a diagram of an architecture of a communication system to which an embodiment of this application is applied. The communication system includes a first apparatus and a second apparatus.

In an implementation method, the first apparatus is a network device or a module used in the network device, and the second apparatus is a terminal device or a module used in the terminal device. The first apparatus and the second apparatus communicate with each other through an air interface.

In another implementation method, the first apparatus is a terminal device or a module used in the terminal device, and the second apparatus is a network device or a module used in the network device. The first apparatus and the second apparatus communicate with each other through an air interface.

In another implementation method, the first apparatus is a network device or a module used in the network device, and the second apparatus is a network device or a module used in the network device. The first apparatus and the second apparatus communicate with each other through an air interface or in a wired manner.

In another implementation method, the first apparatus is a terminal device or a module used in the terminal device, and the second apparatus is a terminal device or a module used in the terminal device. The first apparatus and the second apparatus communicate with each other through an air interface.

Certainly, the first apparatus and the second apparatus in this embodiment of this application may alternatively be devices of other types. For example, the first apparatus may be a device like a cloud device or a cloud server, and the second apparatus is a device like a cloud device or a cloud server. This is not limited in this application.

A terminal device in embodiments of this application may be a device having a wireless transceiver function, and may specifically be user equipment (user equipment, UE), an access terminal, a subscriber unit (subscriber unit), a subscriber station, a mobile station (mobile station), a remote station, a remote terminal, a mobile device, a user terminal, a wireless communication device, a user agent, or a user apparatus. The terminal device may be deployed on the land, including an indoor device, an outdoor device, a handheld device, or a vehicle-mounted device, may be deployed on a water surface (for example, on a ship), or may be deployed in the air (for example, on an airplane, a balloon, or a satellite). The terminal device may be a cellular phone, a mobile phone (mobile phone), a tablet computer (pad), a wireless data card, a wireless modem, a satellite terminal, a vehicle (for example, an automobile, a bicycle, an electric vehicle, an airplane, a ship, a train, or a high-speed railway)-mounted device, a mechanical arm, a workshop device, a wearable device (for example, a smartwatch, a smart band, or a pedometer), an uncrewed aerial vehicle, a robot, a smart point of sale (point of sale, POS) terminal, a customer-premises equipment (customer-premises equipment, CPE), a computer having a wireless transceiver function, a virtual reality (virtual reality, VR) terminal device, an augmented reality (augmented reality, AR) terminal device, a terminal device in industrial control (industrial control), a terminal device in self-driving (self-driving), a terminal device in telemedicine (remote medical), a terminal device in a smart grid (smart grid), a terminal in transportation safety (transportation safety), a terminal device in a smart city (smart city), or a terminal in a smart home (smart home) (for example, a smart home device like a refrigerator, a television, an air conditioner, or an electricity meter). The terminal device may alternatively be another device having a function of a terminal. A device form of the terminal is not limited in embodiments of this application. An apparatus configured to implement the function of the terminal device may be a terminal device, or may be an apparatus that can support the terminal device in implementing the function, for example, a chip system. The apparatus may be installed in a terminal device or used in cooperation with the terminal device. In embodiments of this application, the chip system may include a chip, or may include a chip and another discrete device.

A network device in embodiments of this application is a device having a wireless transceiver function, and is configured to communicate with the terminal device or another network device, or may be a device that can connect the terminal device to a wireless network, for example, a radio access network (radio access network, RAN) device or node. The network device in embodiment of this application may include various forms of base stations, for example, a base station (base station), an evolved NodeB (evolved NodeB, eNodeB), a next generation NodeB (next generation NodeB, gNB), a macro base station, a micro base station (also referred to as a small cell), a relay station, an access point, a device that implements a base station function in a communication system evolved after a 5th generation (5th generation, 5G) technology, an access point (access point, AP) in a wireless local area network (wireless local area network, WLAN) system, an integrated access and backhaul (integrated access and backhaul, IAB) node, a transmission and reception point (transmission and reception point, TRP), a transmitting point (transmitting point, TP), a mobile switching center, and a device functioning as a base station in device-to-device (Device-to-Device, D2D), vehicle-to-everything (vehicle-to-everything, V2X), or machine-to-machine (machine-to-machine, M2M) communication, and may further include a network device in a non-terrestrial network (non-terrestrial network, NTN) communication system, that is, may be deployed on a high-altitude platform or a satellite. In some possible scenarios, different network devices separately implement some functions of the base station. For example, the network device may be a central unit (central unit, CU), a distributed unit (distributed unit, DU), a CU-control plane (control plane, CP), a CU-user plane (user plane, UP), or a radio unit (radio unit, RU). The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), an active antenna unit (active antenna unit, AAU), or a remote radio head (remote radio head, RRH). It may be understood that the network device may be a CU node, a DU node, or a device including a CU node and a DU node. In addition, the CU may be classified as a network device in an access network RAN, or the CU may be classified as a network device in a core network CN. This is not limited herein.

In different systems, the CU (or a CU-CP and a CU-UP), the DU, or the RU may alternatively have different names, and a person skilled in the art may understand meanings of the names. For example, in an open RAN (open RAN, ORAN) system, the CU may also be referred to as an O-CU (open CU), the DU may also be referred to as an O-DU, the CU-CP may also be referred to as an O-CU-CP, the CU-UP may also be referred to as an O-CU-UP, and the RU may also be referred to as an O-RU. For ease of description, the CU, the CU-CP, the CU-UP, the DU, and the RU are used as examples for description in this application. Any one of the CU (or the CU-CP and the CU-UP), the DU, and the RU in this application may be implemented by using a software module, a hardware module, or a combination of a software module and a hardware module.

A form of the network device is not limited in embodiments of this application. An apparatus configured to implement a function of the network device may be a network device, or may be an apparatus, for example, a chip system, that can support the network device in implementing the function. The apparatus may be installed in the network device or used in cooperation with the network device.

In an evolution process of a communication system, a high throughput and massive connectivity have always been core challenges for a wireless communication network. To cope with the foregoing challenges, 5G communication proposes applications such as enhanced mobile broadband (enhanced mobile broadband, eMBB), ultra-reliable and ultra-low latency communication (ultra-reliable and ultra-low latency communication, URLLC), and massive machine type communication (massive machine type communication, mMTC) as technical objectives. However, a 6G communication system evolved after 5G will definitely evolve towards a direction, for example, a higher throughput, a lower latency, higher reliability, a larger quantity of connections, and higher spectrum utilization.

With continuous development of three driving forces of AI/machine learning (machine learning, ML): a computing capability-related technology, an algorithm-related technology, and a data-related technology, AI/ML has significant application potential in many aspects such as modeling and learning in a complex and unknown environment, channel prediction, intelligent signal generation and processing, network status tracking and intelligent scheduling, and network optimization and deployment.

An AI technology may be implemented based on interaction between a plurality of devices. For a large-scale AI model, when there are large differences between computing capabilities and storage capabilities of devices, AI model training and inference may be performed by different devices. For example, in comparison with a terminal device, a network device having stronger computing and storage capabilities may be configured to perform AI model training. After the model training ends, the network device may distribute the AI model to the terminal device, and the terminal device implements AI model inference by using the received AI model. In an inference phase, when collection of sample data is related to an environment change, collected sample data changes as an external environment changes. As a result, current sample data may not match the previously received AI model. In this case, the network device needs to deliver an updated AI model to the terminal device.

An AI model training process may alternatively be jointly completed by a plurality of devices through cooperation. For example, in distributed learning, a plurality of terminal devices independently perform AI model training by using local sample data, and send a weight (weight) or a gradient (gradient) of the model in the training process to the network device. The network device performs aggregation (aggregation) on a plurality of received weights or gradients of the model, and then delivers an aggregation result to the plurality of terminal devices. The foregoing process is iterated until the model converges.

Based on an application scenario of the AI technology, a scale of the AI model may be very large, and an order of magnitude of data of the AI model may reach a million level or even a ten-million level. As a result, when the data of the AI model needs to be exchanged between different devices, extremely high transmission resource overheads are caused. Especially in a scenario in which a plurality of terminal devices participate, for example, in a scenario of distributed learning, transmission overheads further increase. Therefore, in a case of increasingly strained transmission resources, how to transmit data of an ultra-large-scale AI model has become a key problem to be urgently resolved in the AI field.

FIG. 2 is a schematic flowchart of a data transmission method according to an embodiment of this application. The method includes the following steps.

Step 201: A first apparatus determines compressed data based on N data blocks corresponding to an AI model.

One AI model includes one or more layers, and a data block of the AI model may be divided into N data blocks, where N is an integer greater than 1. One data block may correspond to a part of nodes at one layer of the AI model, that is, a part of nodes at one layer are grouped into one data block. Alternatively, one data block may correspond to one layer of the AI model, that is, all nodes at one layer are grouped into one data block. Alternatively, one data block may correspond to a plurality of layers of the AI model, that is, all nodes at the plurality of layers are grouped into one data block. Alternatively, one data block may correspond to a part of nodes at a plurality of layers of the AI model, that is, a part of nodes at the plurality of layers are grouped into one data block.

A compression scheme corresponding to each of the N data blocks is related to a distribution feature of the data block, the determined compressed data includes M compressed blocks, the M compressed blocks are in one-to-one correspondence with M data blocks in the N data blocks, and M is an integer not greater than N. The compression scheme may also be understood as a compression algorithm.

Step 202: The first apparatus sends the compressed data to a second apparatus. Correspondingly, the second apparatus receives the compressed data.

In an implementation method, N=M indicates that after data of the AI model is divided into the N data blocks, each of the N data blocks is compressed into one compressed block to obtain M compressed blocks, and then the M compressed blocks are sent to the second apparatus.

In another implementation method, N>M>0 indicates that after data of the AI model is divided into the N data blocks, the M data blocks in the N data blocks each are compressed into one compressed block, to obtain M compressed blocks, and then the M compressed blocks are sent to the second apparatus. Other N-M data blocks in the N data blocks are not compressed before being transmitted to the second apparatus, and are not directly transmitted to the second apparatus without being compressed. This method is applicable to a case in which a part of data of a trained AI model changes slightly or does not change in comparison with a corresponding part of data of a historical AI model. The first apparatus may not directly send the part of data that changes slightly or does not change to the second apparatus, and does not compress the part of data that changes slightly or does not change before sending the data to the second apparatus. The second apparatus may directly use the part of data corresponding to the historical AI model.

In another implementation method, M=0 indicates that no data of the AI model is compressed before being transmitted to the second apparatus, and no data of the AI model is directly transmitted to the second apparatus without being compressed. This method is applicable to a case in which a trained AI model changes slightly or does not change in comparison with a historical AI model. The first apparatus does not need to directly send data of the trained AI model to the second apparatus or send the data to the second apparatus after compression, and the second apparatus may directly use the historical AI model.

For the first two implementation methods, when one data block is compressed into one compressed block, a used compression ratio may be equal to 1, or may be a value greater than 0 and less than 1. When a compression ratio corresponding to a data block is equal to 1, it indicates that the data block is not compressed. Therefore, a compressed block corresponding to the data block is the data block itself, or it is understood that the compressed block and the data block include same data. When a compression ratio corresponding to a data block is greater than 0 and less than 1, a compressed block is obtained by compressing the data block, and an amount of data included in the compressed block is less than that of data included in the data block corresponding to the compressed block.

In an implementation method, in this application, data blocks corresponding to the AI model are grouped into at least three types of data blocks, and the three types of data blocks are respectively referred to as a first data block, a second data block, and a third data block. In this application, the N data blocks corresponding to the AI model may include only one type of data blocks, or may include two types of data blocks, or may include three types of data blocks.

The first data block is a data block whose importance degree is greater than a first threshold. The importance degree may be referred to as importance. The first data block is also referred to as an important data block. For the first data block, the first apparatus does not perform compression, or it is understood that a compression ratio is 1. Therefore, a compressed block corresponding to each first data block is the first data block itself. For example, when the N data blocks include N₁ first data blocks, where N₁ is a positive integer, the M compressed blocks determined by the first apparatus include at least N₁ compressed blocks, and the Ni compressed blocks are the Ni first data blocks. Alternatively, it is understood that the M compressed blocks determined by the first apparatus include at least the N₁ first data blocks.

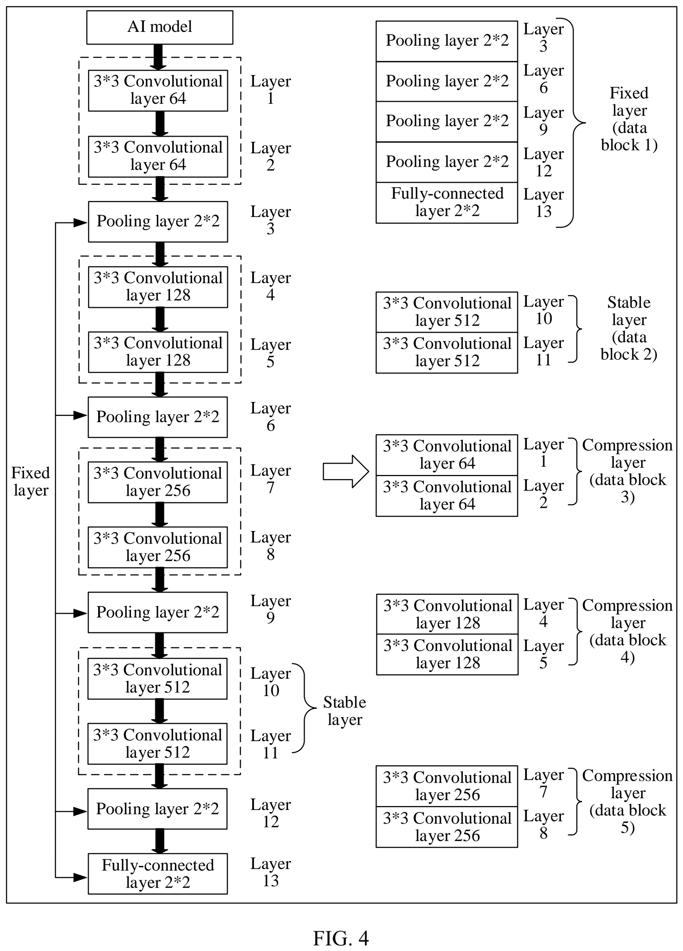

In an implementation method, the importance degree of the first data block may be determined by using the following method: In a training process of the AI model, in an initial training phase, a parameter of the entire AI model has not reached a stable state. In this case, data close to an input layer is more important than data close to an output layer. As a quantity of training iterations increases, when the AI model is approaching convergence, the data close to the output layer is more important than the data close to the input layer. FIG. 4 is used as an example. When training is approaching convergence, data at a fully connected layer that is used as a last layer is more important. Specifically, training phases may be classified based on accuracy of the AI model. For example, a training phase for which the accuracy is lower than a first accuracy threshold is an initial training phase, a training phase for which the accuracy is higher than a second accuracy threshold is a final training phase, and a training phase for which the accuracy is within the first accuracy threshold and the second accuracy threshold is an intermediate training phase. It is assumed that the importance or the importance degree is represented by a number from 0 to 1, where 1 indicates highest importance, and 0 indicates lowest importance. The N data blocks are sequentially sorted based on a forward propagation sequence. For the initial training phase, importance of the N data blocks is respectively N/N, (N-1)/N, (N-2)/N, ..., and 1/N. For the final training phase, the importance of the N data blocks is respectively 1/N, 2/N, ..., (N-1)/N, and N/N. For the intermediate training phase, importance of each of the N data blocks is x/N. The first accuracy threshold, the second accuracy threshold, and x are preconfigured parameters. Based on the foregoing definition of the importance, a current training phase, that is, the initial training phase, the intermediate training phase, or the final training phase, is first determined based on the accuracy of the AI model, and then the importance of the N data blocks is determined based on the method for determining importance corresponding to a training phase. A data block whose importance is greater than the first threshold is the foregoing first data block. The first threshold is also a preconfigured parameter, and is a number greater than 0 and less than 1.

In addition, an importance degree of data may be further determined based on a function of each layer of the AI model. For example, a function of a pooling layer is performing dimension reduction on data. To ensure that a dimension reduction operation does not cause a loss to an information amount of the data, a size of a perception field of the pooling layer is data of high importance. Specifically, importance of data at the pooling layer may be set to 1, that is, it is ensured that importance of the pooling layer is higher than the first threshold.

The second data block is a data block that changes slightly. The second data block is also referred to as a stable data block. For example, when the second data block is weight data, a change degree of the second data block is lower than a second threshold. For another example, when the second data block is gradient data, a probability that the second data block is within a stable interval is greater than a third threshold. For the second data block, the first apparatus does not transmit the second data block to the second apparatus, and does not compress the second data block before transmitting the second data block to the second apparatus. Alternatively, it is understood that the second data block does not correspond to the foregoing M transmitted compressed blocks. For example, when the N data blocks include N₂ second data blocks, where N₂ is a positive integer, the M compressed blocks determined by the first apparatus do not include the N₂ second data blocks or do not include compressed data corresponding to the N₂ second data blocks. For the second data block, it may also be understood that a compression ratio corresponding to the second data block is equal to 0.

The third data block is a data block other than the first data block and the second data block, and the third data block is a data block that needs to be actually compressed, where actual compression means that a compression ratio of the third data block is greater than 0 and less than 1. The third data block is also referred to as a compressed data block. For the third data block, the first apparatus needs to compress the third data block and then transmit the compressed third data block to the second apparatus, and a compression ratio is greater than 0 and less than 1. For example, when the N data blocks include N₃ third data blocks, where N₃ is a positive integer, the M compressed blocks determined by the first apparatus include at least N₃ compressed blocks, the N₃ compressed blocks are in one-to-one correspondence with the N₃ third data blocks, and an amount of data of each compressed block is less than that of a third data block corresponding to the compressed block.

Each third data block includes one or more sub-data blocks. When one third data block includes a plurality of sub-data blocks, a difference degree between distribution information of any two of the plurality of sub-data blocks is less than a fourth threshold, and each sub-data block corresponds to a part of nodes at a layer, a part of nodes at a plurality of layers, one layer, or a plurality of layers of the AI model. Alternatively, when the N data blocks include a plurality of third sub-data blocks, a difference degree between distribution information of any two third data blocks in the plurality of third data blocks is greater than a fifth threshold. In an implementation method, when a difference degree between distribution information of two sub-data blocks or a difference degree between distribution information of two third data blocks is compared, a probability density function (probability density function, PDF) or a cumulative distribution function (cumulative distribution function, CDF) of distribution information of the sub-data blocks or the third data blocks may be first determined, and then the difference degree between the distribution information of the two sub-data blocks or the difference degree between the distribution information of the two third data blocks is compared based on the PDF or the CDF.

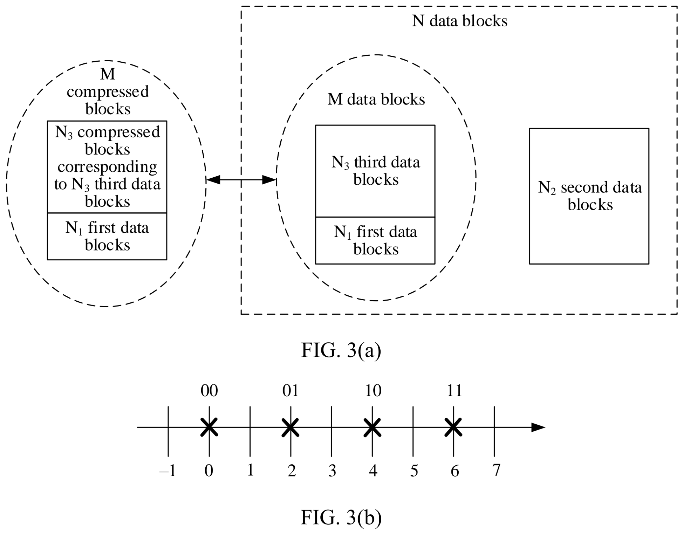

FIG. 3(a) is an example diagram of an association between a data block and a compressed block according to an embodiment of this application. The N data blocks include N₁ first data blocks, N₂ second data blocks, and N₃ third data blocks, and N₁+N₃ is equal to M. The N₃ third data blocks are compressed into N₃ compressed blocks, and the N₁ first data blocks are not compressed and are directly used as N₁ compressed blocks. Therefore, M compressed blocks are obtained. The N₂ second data blocks are not compressed and are not directly used as compressed blocks. Therefore, the M compressed blocks do not include the second data block or a compressed second data block.

Step 203: The first apparatus sends a compression parameter to the second apparatus. Correspondingly, the second apparatus receives the compression parameter.

Step 203 is an optional step. When step 203 is performed, a sequence of step 203 and step 202 is not limited. Alternatively, step 203 and step 202 may be combined into one step. For example, the first apparatus sends a first message to the second apparatus, where the first message includes the compression parameter and the compressed data.

In an implementation method, when the compression parameter and the compressed data are transmitted simultaneously, the compression parameter and the compressed data may be specifically transmitted on a same time-frequency resource block. A location that is of a resource carrying the compression parameter and that is in an entire transmission resource block may be determined based on a predefinition or a direct indication, and a remaining resource may be used for transmission of the compressed data.

In another implementation method, when the compression parameter and the compressed data are transmitted on different resources, the compression parameter may be separately carried in a control message for transmission.

The compression parameter indicates one or more of the following: a model parameter of the AI model, a compression granularity corresponding to each of the N data blocks, or the compression scheme corresponding to each of the N data blocks.

The model parameter of the AI model includes at least one of the following:
(1) a type of the AI model, where
   the type of the AI model includes but is not limited to: a deep neural network (deep neural network, DNN), a convolutional neural network (convolutional neural network, CNN), a regression neural network (regression neural network, RNN), and a generative adversarial network (generation adversarial network, GAN);
(2) a quantity of layers of the AI model;
(3) a quantity of nodes at each layer of the AI model; or
(4) a function of each layer of the AI model, where
the function of the layer of the AI model includes but is not limited to: a convolutional layer, a pooling layer, a fully connected (fully connected, FC) layer, an impulse function layer, or a batch normalization (batch normalization, BN) layer.

The compression granularity of each of the N data blocks may be a part of nodes at a layer, or one layer, or a plurality of layers.

The compression scheme may include one or more of the following: a sparse algorithm, quantization, matrix factorization, complete compression, or no compression.

**In** an implementation method, a mapping relationship between an index of a compression scheme and the compression scheme and a parameter of the compression scheme may be preconfigured on the first apparatus and the second apparatus, or the mapping relationship may be predefined according to a protocol. After determining the compression scheme and a parameter of the compression scheme that correspond to each data block, the first apparatus determines an index of the compression scheme based on the mapping relationship, and includes the index of the compression scheme in the compression parameter. The second apparatus obtains the index of the compression scheme from the compression parameter, and determines, based on the index, a corresponding compression scheme and a parameter of the compression scheme from the mapping relationship. In this method, an index indicates a compression scheme, so that indication efficiency can be improved and resource overheads can be reduced.

For example, Table 1-1 shows a mapping relationship between an index of a compression scheme and the compression scheme and a parameter of the compression scheme.

**Table 1-1**

| Index of a compression scheme | Compression scheme | Parameter of the compression scheme |
|---|---|---|
| 1 | Sparse algorithm | Compression ratio/Transformation matrix/Sequence+ |
| 2 | Quantization | Mapping relationship 1 for a quantized bit |
| 3 | Quantization | Mapping relationship 2 for a quantized bit |
| 4 | Sparsification + Quantization | Compression ratio/Transformation matrix/Sequence; Mapping relationship 1 for a quantized bit |
| 5 | Matrix factorization + Quantization | Mapping relationship 1 for a quantized bit; Fixed matrix (index) |
| 6 | Matrix factorization + Quantization | Mapping relationship 2 for a quantized bit; Fixed matrix (index) |
| 7 | Matrix factorization + Sparsification + Quantization | Compression ratio/Transformation matrix/Sequence; Mapping relationship 1 for a quantized bit; Fixed matrix (index) |
| 8 | Matrix factorization + Sparsification + Quantization | Compression ratio/Transformation matrix/Sequence; Mapping relationship 2 for a quantized bit; Fixed matrix (index) |
| 9 | Complete compression | None |
| 10 | No compression | None |

The sparse algorithm includes top sparsification and contour sparsification. For the top sparsification, raw data is sorted based on absolute values, and finally, only the first r% data with maximum absolute values needs to be transmitted, and a parameter that needs to be indicated is a compression ratio r%. For the contour sparsification, raw data is converted into compressed data by using a deformation matrix or sequence, and a parameter that needs to be indicated is a transformation matrix or sequence.

Quantization is a process of converting raw data or data that is compressed by using another algorithm into bits. A parameter that needs to be indicated is a quantity of quantized bits, that is, a quantity of bits converted from each piece of raw data, and a mapping relationship for a quantized bit. FIG. 3(b) is an example diagram of a quantization manner. In this example, data within a range of {-1, 1} is mapped to 0, and corresponding quantized bits are 00. Data within a range of {1, 3} is mapped to 2, and corresponding quantized bits are 01. Data within a range of {3, 5} is mapped to 4, and corresponding quantized bits are 10. Data within a range of {5, 7} is mapped to 6, and corresponding quantized bits are 11. Table 2 is an example of a mapping relationship. The second apparatus may determine, based on the mapping relationship, data corresponding to a received bit. If received bits are 00, it is determined that corresponding data is 0. If received bits are 01, it is determined that corresponding data is 2. If received bits are 10, it is determined that corresponding data is 4. If received bits are 11, it is determined that corresponding data is 6.

**Table 2**

| Bits | Data |
|---|---|
| 00 | 0 |
| 01 | 2 |
| 10 | 4 |
| 11 | 6 |

For the complete-compression scheme corresponding to the index 9 in Table 1-1, a compression ratio is 0, and data is compressed to a minimum size (that is, no data exists after the compression), corresponding to the foregoing second data block. In other words, a compression ratio of the second data block is 0, and therefore, no content of the second data block is actually transmitted.

For the no-compression scheme corresponding to the index 10 in Table 1-1, a compression ratio is 1, and data is not compressed. A transmitted compressed block pair is a data block itself. Alternatively, it is understood that the compressed block and the data block include same data, corresponding to the first data block.

Table 1-1 may also be split into two tables and the two tables are stored on the first apparatus and the second apparatus. For example, Table 1-1 may be split into the following Table 1-2 and Table 1-3.

**Table 1-2**

| Index of a compression scheme | Compression scheme |
|---|---|
| 1 | Sparse algorithm |
| 2 | Quantization 1 |
| 3 | Quantization 2 |
| 4 | Sparsification + Quantization 1 |
| 5 | Matrix factorization + Quantization 1 |
| 6 | Matrix factorization + Quantization 2 |
| 7 | Matrix factorization + Sparsification + Quantization 1 |
| 8 | Matrix factorization + Sparsification + Quantization 2 |
| 9 | Complete compression |
| 10 | No compression |

**Table 1-3**

| Compression scheme | Parameter of the compression scheme |
|---|---|
| Sparse algorithm | Compression ratio/Transformation matrix/Sequence+ |
| Quantization 1 | Mapping relationship 1 for a quantized bit |
| Quantization 2 | Mapping relationship 2 for a quantized bit |
| Sparsification + Quantization 1 | Compression ratio/Transformation matrix/Sequence; Mapping relationship 1 for a quantized bit |
| Matrix factorization + Quantization 1 | Mapping relationship 1 for a quantized bit; Fixed matrix (index) |
| Matrix factorization + Quantization 2 | Mapping relationship 2 for a quantized bit; Fixed matrix (index) |
| Matrix factorization + Sparsification + Quantization 1 | Compression ratio/Transformation matrix/Sequence; Mapping relationship 1 for a quantized bit; Fixed matrix (index) |
| Matrix factorization + Sparsification + Quantization 2 | Compression ratio/Transformation matrix/Sequence; Mapping relationship 2 for a quantized bit; Fixed matrix (index) |
| Complete compression | None |
| No compression | None |

Table 1-3 may also be split into a plurality of tables. For example, each compression scheme and the parameter of the compression scheme corresponding to the compression scheme separately form a table.

In another implementation method, a mapping relationship between an index of a compression scheme and a parameter of the compression scheme may be preconfigured on the first apparatus and the second apparatus, or may be predefined according to a protocol. After determining the compression scheme and a parameter of the compression scheme that correspond to each data block, the first apparatus determines an index of the compression scheme based on the mapping relationship, and includes the index of the compression scheme in the compression parameter. The second apparatus obtains the index of the compression scheme from the compression parameter, and determines, based on the index, a parameter of the corresponding compression scheme from the mapping relationship, where the parameter of the compression scheme corresponds to one compression scheme. In this method, an index indicates a compression scheme, so that indication efficiency can be improved and resource overheads can be reduced.

For example, Table 1-4 shows a mapping relationship between an index of a compression scheme and a parameter of the compression scheme.

**Table 1-4**

| Index of a compression scheme | Parameter of the compression scheme |
|---|---|
| 1 | Compression ratio/Transformation matrix/Sequence+ |
| 2 | Mapping relationship 1 for a quantized bit |
| 3 | Mapping relationship 2 for a quantized bit |
| 4 | Compression ratio/Transformation matrix/Sequence; Mapping relationship 1 for a quantized bit |
| 5 | Mapping relationship 1 for a quantized bit; Fixed matrix (index) |
| 6 | Mapping relationship 2 for a quantized bit; Fixed matrix (index) |
| 7 | Compression ratio/Transformation matrix/Sequence; Mapping relationship 1 for a quantized bit; Fixed matrix (index) |
| 8 | Compression ratio/Transformation matrix/Sequence; Mapping relationship 2 for a quantized bit; Fixed matrix (index) |
| 9 | None |
| 10 | None |

In another implementation method, a first mapping relationship between an index of a compression scheme and the compression scheme and a second mapping relationship between an index of a compression scheme and a parameter of the compression scheme may be further preconfigured on the first apparatus and the second apparatus, or may be predefined according to a protocol. After determining the compression scheme and a parameter of the compression scheme that correspond to each data block, the first apparatus determines an index of the compression scheme based on the mapping relationship, and includes the index of the compression scheme in the compression parameter. The second apparatus obtains the index of the compression scheme from the compression parameter, determines, based on the index, a corresponding compression scheme from the first mapping relationship, and determines a corresponding compression parameter from the second mapping relationship. In this method, an index indicates a compression scheme and a parameter of the compression scheme, so that indication efficiency can be improved and resource overheads can be reduced.

For example, Table 1-5 shows a first mapping relationship between an index of a compression scheme and the compression scheme. For example, Table 1-6 shows a second mapping relationship between an index of a compression scheme and the parameter of a compression scheme.

**Table 1-5**

| Index of a compression scheme | Compression scheme |
|---|---|
| 1 | Sparse algorithm |
| 2 | Quantization |
| 3 | Quantization |
| 4 | Sparsification + Quantization |
| 5 | Matrix factorization + Quantization |
| 6 | Matrix factorization + Quantization |
| 7 | Matrix factorization + Sparsification + Quantization |
| 8 | Matrix factorization + Sparsification + Quantization |
| 9 | Complete compression |
| 10 | No compression |

**Table 1-6**

| Index of a compression scheme | Parameter of a compression scheme |
|---|---|
| 1 | Compression ratio/Transformation matrix/Sequence+ |
| 2 | Mapping relationship 1 for a quantized bit |
| 3 | Mapping relationship 2 for a quantized bit |
| 4 | Compression ratio/Transformation matrix/Sequence; Mapping relationship 1 for a quantized bit |
| 5 | Mapping relationship 1 for a quantized bit; Fixed matrix (index) |
| 6 | Mapping relationship 2 for a quantized bit; Fixed matrix (index) |
| 7 | Compression ratio/Transformation matrix/Sequence; Mapping relationship 1 for a quantized bit; Fixed matrix (index) |
| 8 | Compression ratio/Transformation matrix/Sequence; Mapping relationship 2 for a quantized bit; Fixed matrix (index) |
| 9 | None |
| 10 | None |

Step 204: The second apparatus determines the AI model based on the compressed data.

When step 203 is performed, step 204 is: The second apparatus determines the AI model based on the compressed data and the compression parameter.

In the foregoing solution, the compression scheme corresponding to each data block is determined based on the distribution features of the N data blocks corresponding to the AI model, so that most matching compression schemes can be selected for different data blocks, instead of selecting a same compression scheme for all the data blocks. This helps improve compression effect of the AI model, to reduce transmission resources used for transmission of a compressed data block.

The following provides description with reference to a specific example. FIG. 4 is an example diagram of an AI model according to an embodiment of this application. It should be noted that the AI model in this application is not limited to the specific AI model shown in FIG. 4. Refer to FIG. 4, the AI model includes 13 layers, which are sequentially as follows:
Layer 1 is a convolutional layer, where a size of a convolution kernel is 3*3, and a quantity of convolution kernels is 64.
Layer 2 is a convolutional layer, where a size of a convolution kernel is 3*3, and a quantity of convolution kernels is 64.
Layer 3 is a pooling layer, where a size of a perception field (perception field) is 2*2.
Layer 4 is a convolutional layer, where a size of a convolution kernel is 3*3, and a quantity of convolution kernels is 128.
Layer 5 is a convolutional layer, where a size of a convolution kernel is 3*3, and a quantity of convolution kernels is 128.
Layer 6 is a pooling layer, where a size of a perception field is 2*2.
Layer 7 is a convolutional layer, where a size of a convolution kernel is 3*3, and a quantity of convolution kernels is 256.
Layer 8 is a convolutional layer, where a size of a convolution kernel is 3*3, and a quantity of convolution kernels is 256.
Layer 9 is a pooling layer, where a size of a perception field is 2*2.
Layer 10 is a convolutional layer, where a size of a convolution kernel is 3*3, and a quantity of convolution kernels is 512.
Layer 11 is a convolutional layer, where a size of a convolution kernel is 3*3, and a quantity of convolution kernels is 512.
Layer 12 is a pooling layer, where a size of a perception field is 2*2.
Layer 13 is a fully connected layer with an output dimension of 2*2.

In an implementation method, in this application, a plurality of layers of the AI model are classified into layers of different types. Specifically, the plurality of layers of the AI model are classified into a fixed layer, a stable layer, and a compression layer. Descriptions are separately provided below.

### 1. Fixed layer

The fixed layer includes one or more layers of high importance in the AI model. To ensure that a loss of information is not caused to data of high importance due to compression, in this application, data at the fixed layer is directly transmitted without being compressed, and it may also be considered that a compression ratio of the data at the fixed layer is 1. In this method, it is ensured that a loss of an information amount is not caused to the data of high importance due to compression.

The data at the fixed layer may be divided into one or more data blocks, and the one or more data blocks are the foregoing first data block. FIG. 4 is used as an example. The layer 3, the layer 6, the layer 9, the layer 12, and the layer 13 of the AI model are determined as fixed layers. Data at the fixed layer as a whole is divided into one data block, that is, a data block 1. The data block 1 is a specific example of the foregoing first data block. Certainly, the fixed layer may alternatively be divided into a plurality of first data blocks in another division manner. This is not limited in this application.

### 2. Stable layer

During AI model training, a weight of the model and a gradient of the weight are continuously updated through iteration. When data at some layers changes slowly, the layer may be determined as a stable layer. For example, a weight of the AI model is exchanged by the first apparatus. If a data difference between a weight of a layer that is not updated and an updated weight of the layer is small, the weight of the layer may not need to be exchanged. In other words, it is considered that a compression ratio is 0, and the second apparatus may continue to use a previously received weight of the layer. For another example, a gradient of the AI model is exchanged. If data of a gradient of a layer in an iteration is very small, it may be considered that a weight corresponding to the gradient changes very slowly, and gradient information of the layer does not need to be exchanged. In other words, it is considered that a compression ratio is 0, and the second apparatus may set the gradient corresponding to the layer to 0. In this method, data at the stable layer is not transmitted, so that resource occupation can be reduced, and resource utilization can be improved.

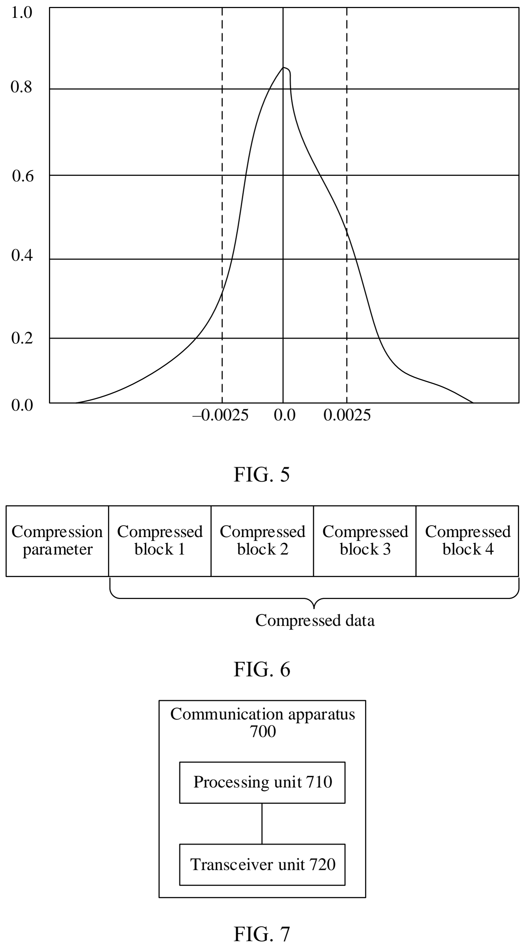

FIG. 5 is an example diagram of a method for determining the stable layer according to an embodiment of this application. For example, data of the AI model is gradient data. When a probability that data at a layer is within a stable interval is greater than a predefined stable threshold, the layer is determined as the stable layer. In FIG. 5, the stable interval is [-0.0025, 0.0025]. In the method, the stable layer may be accurately determined, to improve resource utilization.

The data at the stable layer may be divided into one or more data blocks, and the one or more data blocks are the foregoing second data block. FIG. 4 is used as an example. The layer 10 and the layer 11 of the AI model are determined as stable layers. Data at the stable layer as a whole is divided into one data block, that is, a data block 2. The data block 2 is a specific example of the foregoing second data block. Certainly, the stable layer may alternatively be divided into a plurality of second data blocks in another division manner. This is not limited in this application.

### 3. Compression layer

The compression layer is a layer other than the fixed layer and the stable layer, and a compression ratio corresponding to data at the compression layer is greater than 0 and less than 1. The data at the compression layer may be divided into one or more data blocks, and the one or more data blocks are the foregoing third data block. An independent compression scheme is used for compression of each third data block. A compression granularity of each third data block may be any one of the following:
(1) Layer: Each compression layer is used as one compressed block (namely, one third data block). Each compression layer is used as one compressed block (namely, the third data block), and an independent compression scheme is used.
(2) Layer group: In the AI model, a plurality of compression layers with a same structure often consecutively appear. The layers with the same structure may form one layer group, each layer group is used as one compressed block (namely, one third data block), and an independent compression scheme is used. A layer group may be formed in the following manners:
   Manner 1: Adjacent layers with a same structure form one layer group. When a structure of the AI model is determined, a layer group is also determined. In this manner, a layer index does not need to be indicated.
   Manner 2: Adjacent layers with a same structure may be further divided into a plurality of layer groups based on a segmentation layer index. During identification of a layer group, a first-level layer group may be first obtained by using the adjacent layers with the same structure, and then a final layer group is obtained based on the segmentation layer index. In this manner, the segmentation layer index needs to be indicated.

For example, a layer 5 to a layer 10 of an AI model are of a same structure. If it is determined that the layer 5 and the layer 6 are grouped into one layer group, the layer 7 and the layer 8 are grouped into one layer group, and the layer 9 and the layer 10 are grouped into one layer group, and it is assumed that an index for a last layer in each layer group is used as a segmentation layer index, segmentation layer indexes for the three layer groups are 6 and 8. Therefore, the first-level layer group includes the layer 5 to the layer 10, and the segmentation layer indexes are 6 and 8, indicating that the layer 5 and the layer 6 in the layer 5 to the layer 10 are grouped into one layer group, the layer 7 and the layer 8 of the layer 5 to the layer 10 are grouped into one layer group, and the layer 9 and the layer 10 of the layer 5 to the layer 10 are grouped into one layer group.

Manner 3: Flexible layer group division is performed. A layer index included in each layer group is directly indicated to the second apparatus, and optionally, a quantity of layer groups may be further indicated.

(3) Data group: When a quantity of nodes included in some layers is greater than a preset node quantity threshold, data included in the layers may be divided into a plurality of data groups, or when node data included in some layers is less than a preset node data threshold, data at a plurality of layers may be combined into one data group. Each data group is used as one compressed block (namely, the third data block), and an independent compression scheme is used.

In an implementation method, a compression ratio corresponding to the third data block may be determined by using the following method: First, an initial compression ratio is determined as: *δ = Lₛ*/*N,* where *Lₛ* is an amount of data that is of the third data block and that is beyond a stable interval, *N* is a total data amount of the third data block, and a unit of *Lₛ* and *N* may be bits. A value of the stable interval herein may be the same as or different from a value of the stable interval corresponding to the second data block. This is not limited herein. Then, a maximum quantity *L_{MCS}* of bits that are allowed to be carried in the third data block is determined based on modulation and coding measurement (modulation and coding scheme, MCS) and a resource used for transmission of the third data block. If *L_{MCS}* < *Lₛ,* δ is reduced until *L_{MCS} > Lₛ* is satisfied.

For example, the compression ratio may be further updated in a training process. An update criterion may be based on evaluation of AI model performance, for example, change degrees of accuracy and a loss in a period of time. A specific criterion may be *Aₗₒₛₛ > Lₗₒₛₛ* and/or *A_{accuracy} < L_{accuracy},* where *A_{accuracy}* and *Aₗₒₛₛ* are accuracy and a loss of the AI model in a current training phase, and *L_{accuracy}* and *Lₗₒₛₛ* are accuracy and a loss of the AI model in a previous training phase. If the accuracy of the AI model decreases or the loss of the AI model increases, it indicates that a current compression ratio does not match an existing AI model. In this case, the compression ratio needs to be updated, and the compression ratio can be appropriately improved to improve the performance of the AI model. In this method, the compression ratio is adjusted in a timely manner, so that working efficiency of an AI module and spectral efficiency of a transmission resource can be improved.

For example, *Lₗₒₛₛ* is a loss of the AI model in a previous training epoch, or a loss of the AI model in a previous N^{th} (where N is greater than 1) training epoch before a current epoch, or an average value of losses of the AI model in latest M (where M is greater than 1) training epochs, or a loss of the AI model in a training phase at a previous time point, or an average value of losses of the AI model in a training phase in a previous time period. This is not limited in this application.

For example, *L_{accuracy}* is accuracy of the AI model in a previous training epoch, or accuracy of the AI model in a previous K^{th} (where K is greater than 1) training epoch, or an average value of accuracy of the AI model in latest L (where L is greater than 1) training epochs, or accuracy of the AI model in a training phase at a previous time point, or an average value of accuracy of the AI model in a previous training phase in a previous time period. This is not limited in this application.

FIG. 4 is used as an example. The layer 1, the layer 2, the layer 4, the layer 5, the layer 7, and the layer 8 of the AI model are determined as compression layers. Because the layer 1 and the layer 2 are of a same structure, the layer 1 and the layer 2 are determined as one data block, that is, a data block 3. Because the layer 4 and the layer 5 are of a same structure, the layer 4 and the layer 5 are determined as one data block, that is, a data block 4. Because the layer 7 and the layer 8 are of a same structure, the layer 7 and the layer 8 are determined as one data block, that is, a data block 5. The data block 3, the data block 4, and the data block 5 are all the foregoing third data blocks.

In the example in FIG. 4, the first apparatus determines five data blocks corresponding to the AI model, which are respectively the data blocks 1 to 5. The data block 1 corresponds to the data at the fixed layer, the data block 2 corresponds to the data at the stable layer, and the data blocks 3 to 5 correspond to the data at the compression layer. The first apparatus determines, based on the five data blocks, four compressed blocks, which are respectively compressed blocks 1 to 4. The compressed block 1 is the same as the data block 1, and the compressed block 2 is a data block obtained through compression of the data block 3, the compressed block 3 is a data block obtained through compression of the data block 4, and the compressed block 4 is a data block obtained through compression of the data block 5.

Then, the first apparatus sends a compression parameter and compressed data to the second apparatus. FIG. 6 is an example diagram of transmitted data according to an embodiment of this application. The transmitted data includes a compression parameter and compressed data, and the compressed data includes the compressed blocks 1 to 4. The compression parameter includes information such as a model parameter of the AI model, an index for the fixed layer of the AI model, an index for the stable layer of the AI model, and a compression scheme corresponding to each data block.

After receiving the compression parameter and the compressed data of the AI model, the second apparatus first identifies the parameter of the AI model and determines a structure of the AI model based on the compression parameter, and then fills the AI model based on a remaining compression parameter, to obtain the AI model shown in FIG. 4.

The second apparatus determines, based on the index for the stable layer of the AI model in the compression parameter, that stable layers are the layer 10 and the layer 11. If the received compressed data is gradient data, a model parameter of the stable layer is set to 0. If the received compressed data is weight data, data that is at a corresponding stable layer and that is received last time continues to be used.

The second apparatus extracts the fixed layer from the compressed data based on the index for the fixed layer of the AI model and a quantity of nodes at the fixed layer in the model parameter of the AI model. In FIG. 4, the fixed layer includes a total of five layers of the AI model in total. It is assumed that a quantity of nodes at each layer is 100, each piece of data at each layer is transmitted by using 32 bits, and the data at the fixed layer is located at a most front end of the compressed data (for example, the compressed block 1 shown in FIG. 6). In this case, 32*5*100 bits are extracted from a start location of the compressed data, and are filled at a corresponding location based on an index for the compression layer.

The second apparatus extracts the remaining compressed data based on a compression scheme. It is assumed that the used compression scheme is top K (Top K) compression. To be specific, compression is performed based on absolute values of raw data, the raw data is sorted based on the absolute values, and finally, only the first r% of data with maximum absolute values needs to be transmitted, where r% is a compression ratio. It is assumed that dimensions of raw data of the compressed blocks 2 to 4 in FIG. 6 are respectively 1000, 2000, and 3000, and compression ratios are respectively 1%, 2%, and 3%. In addition, quantized bits of each piece of data in each compressed block are 2, 2, and 4. Therefore, the second apparatus needs to respectively extract 1000*1%*2, 2000*2%*2, and 3000*3%*4 bits from the compressed data, and fill the extracted bits at corresponding locations.

According to the foregoing method, the second apparatus may decompress the compressed data based on the compression parameter, to obtain data of the AI model.

In the foregoing example, the second apparatus identifies the stable layer, the fixed layer, and the compression layer based on the index for the stable layer and the index for the fixed layer in the compression parameter. In another implementation method, compression granularities respectively corresponding to the data block 1 to the data block 5 and compression schemes respectively corresponding to the data block 1 to the data block 5 may also be carried in the compression parameter. The compression granularity corresponding to each data block indicates a specific layer that is of the AI model and that corresponds to the data block, so that the second apparatus determines a processing manner for the data block according to a compression scheme corresponding to the data block. The data block 1 is used as an example. The compression granularity corresponding to the data block 1 indicates that layers that are of the AI model and that correspond to the data block 1 include the layers 3, 6, 9, 12, and 13, and a compression ratio indicated by the compression scheme is 1. Therefore, after obtaining a received compressed block corresponding to the data block 1, the second apparatus does not need to perform a decompression operation, that is, the received compressed block is the data block 1 itself. The second apparatus then fills the data block 1 in the layers 3, 6, 9, 12, and 13 of the AI model. Similarly, the data block 2 is used as an example. The compression granularity corresponding to the data block 2 indicates that layers that are of the AI model and that correspond to the data block 2 include the layer 10 and the layer 11, and a compression ratio indicated by the compression scheme is 0. If received compressed data is gradient data, model parameters of the layer 10 and the layer 11 are set to 0. If the received compressed data is weight data, data received last time continues to be used at the layer 10 and the layer 11.

It should be noted that in this application, an example in which the foregoing data transmission method is applied to transmission of data of an AI model is used for description. In actual application, the foregoing data transmission method may be further used for transmission of data in another scenario. The another scenario herein may be, for example, a scenario of any type. This is not limited in this application.

It may be understood that, to implement the functions in the foregoing embodiments, the first apparatus or the second apparatus includes corresponding hardware structures and/or software modules for performing the functions. A person skilled in the art should be easily aware that, with reference to units and method steps in the examples described in embodiments disclosed this application, this application can be implemented by hardware or a combination of hardware and computer software. Whether a function is performed by hardware or hardware driven by computer software depends on a particular application scenario and a design constraint condition of the technical solutions.

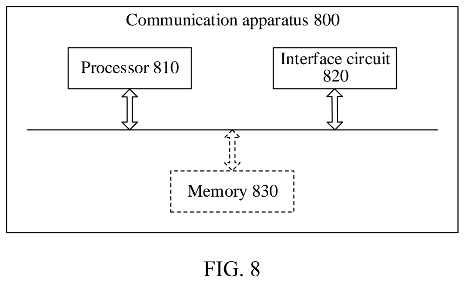

FIG. 7 and FIG. 8 are diagrams of structures of possible communication apparatuses according to embodiments of this application. These communication apparatuses may be configured to implement functions of the first apparatus or the second apparatus in the foregoing method embodiments, and therefore can also achieve the beneficial effects of the foregoing method embodiments. In embodiments of this application, the communication apparatus may be the first apparatus or the second apparatus shown in FIG. 1(b).

The communication apparatus 700 shown in FIG. 7 includes a processing unit 710 and a transceiver unit 720. The communication apparatus 700 is configured to implement the functions of the first apparatus or the second apparatus in the foregoing method embodiments.

When the communication apparatus 700 is configured to implement the functions of the first apparatus in the foregoing method embodiments, the processing unit 710 is configured to determine compressed data based on N data blocks corresponding to an artificial intelligence AI model, where a compression scheme corresponding to each of the N data blocks is related to a distribution feature of the data block, the compressed data includes M compressed blocks, the M compressed blocks are in one-to-one correspondence with M data blocks in the N data blocks, N is an integer greater than 1, and M is an integer not greater than N. The transceiver unit 720 is configured to send the compressed data to a second apparatus.

In a possible implementation method, the M compressed blocks include at least one first data block, the first data block is a data block in the N data blocks, and an importance degree of the first data block is greater than a first threshold.

In a possible implementation method, the N data blocks include at least one second data block, and the second data block does not correspond to the M compressed blocks.

In a possible implementation method, the second data block is weight data, and a change degree of the second data block is lower than a second threshold. Alternatively, the second data block is gradient data, and a probability that the second data block is within a stable interval is greater than a third threshold.

In a possible implementation method, the transceiver unit 720 is further configured to send a compression parameter to the second apparatus, where the compression parameter indicates one or more of the following information: a model parameter of the AI model, a compression granularity of each of the N data blocks, or a compression scheme corresponding to each of the N data blocks; and the model parameter includes at least one of the following: a type of the AI model, a quantity of layers of the AI model, a quantity of nodes at each layer of the AI model, or a function of each layer of the AI model.

In a possible implementation method, the compression granularity of each of the N data blocks is a part of nodes at a layer, one layer, or a plurality of layers of the AI model.

In a possible implementation method, the M data blocks include at least one third data block, the third data block includes one sub-data block or a plurality of sub-data blocks, and a difference degree between distribution information of any two of the plurality of the sub-data blocks is less than a fourth threshold.

When the communication apparatus 700 is configured to implement the functions of the first apparatus in the foregoing method embodiments, the transceiver unit 720 is configured to receive compressed data from the first apparatus, where the compressed data includes M compressed blocks, the M compressed blocks are in one-to-one correspondence with M data blocks in N data blocks corresponding to an artificial intelligence AI model, a compression scheme corresponding to each of the N data blocks is related to a distribution feature of the data block, N is an integer greater than 1, and M is an integer not greater than N. The processing unit 710 is configured to determine the AI model based on the compressed data.

In a possible implementation method, the M compressed blocks include at least one first data block, the first data block is a data block in the N data blocks, and an importance degree of the first data block is greater than a first threshold.

In a possible implementation method, the N data blocks include at least one second data block, and the second data block does not correspond to the M compressed blocks.

In a possible implementation method, the second data block is weight data, and a change degree of the second data block is lower than a second threshold. Alternatively, the second data block is gradient data, and a probability that the second data block is within a stable interval is greater than a third threshold.

In a possible implementation method, the transceiver unit 720 is further configured to receive a compression parameter from the first apparatus; and determining the AI model based on the compressed data includes: determining the AI model based on the compressed data and the compression parameter, where the compression parameter indicates one or more of the following information: a model parameter of the AI model, a compression granularity of each of the N data blocks, or a compression scheme corresponding to each of the N data blocks; and the model parameter includes at least one of the following: a type of the AI model, a quantity of layers of the AI model, a quantity of nodes at each layer of the AI model, or a function of each layer of the AI model.

In a possible implementation method, the compression granularity of each of the N data blocks is a part of nodes at a layer, one layer, or a plurality of layers of the AI model.

In a possible implementation method, the M data blocks include at least one third data block, the third data block includes one sub-data block or a plurality of sub-data blocks, and a difference degree between distribution information of any two of the plurality of the sub-data blocks is less than a fourth threshold.

For more detailed descriptions about the processing unit 710 and the transceiver unit 720, directly refer to related descriptions in the foregoing method embodiments. Details are not described herein again.

The communication apparatus 800 shown in FIG. 8 includes a processor 810 and an interface circuit 820. The processor 810 and the interface circuit 820 are coupled to each other. It may be understood that the interface circuit 820 may be a transceiver or an input/output interface. Optionally, the communication apparatus 800 may further include a memory 830, configured to: store instructions executed by the processor 810, store input data needed by the processor 810 to run the instructions, or store data generated after the processor 810 runs the instructions. Alternatively, when the processor is a logic circuit (device), the processor is configured to store a configuration file of the logic circuit (device).

When the communication apparatus 800 is configured to implement the foregoing method embodiments, the processor 810 is configured to implement functions of the processing unit 710, and the interface circuit 820 is configured to implement functions of the processing unit 710 and the transceiver unit 720.

It may be understood that, the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any regular processor.

The method steps in embodiments of this application may be implemented by hardware, or may be implemented by executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a compact disc read-only memory (compact disc read-only memory, CD-ROM), or a storage medium in any other form well-known in the art. For example, a storage medium is coupled to a processor, to enable the processor to read information from the storage medium and write information into the storage medium. Certainly, the storage medium may alternatively be a component of the processor. The processor and the storage medium may be located in an ASIC. In addition, the ASIC may be located in the first apparatus or the second apparatus. Certainly, the processor and the storage medium may alternatively exist in the first apparatus or the second apparatus as discrete components.

All or some of the foregoing embodiments may be implemented by using software, hardware, firmware, or any combination thereof. When software is used for implementation, all or some of the embodiments may be implemented in a form of a computer program product. The computer program product includes one or more computer programs or instructions. The computer program (computer program) refers to a group of instructions that indicate each step of an electronic computer or another device having a message processing capability, and is usually written in a programming language and is run on a target architecture. When the computer programs or the instructions are loaded and executed on a computer, all or some of the procedures or functions according to embodiments of this application are performed. The computer may be a general-purpose computer, a dedicated computer, a computer network, a network device, a terminal device, or another programmable apparatus. The computer program or the instructions may be stored in a computer-readable storage medium, or may be transmitted from a computer-readable storage medium to another computer-readable storage medium. For example, the computer program or the instructions may be transmitted from a website, computer, server, or data center to another website, computer, server, or data center in a wired or wireless manner. The computer-readable storage medium may be any usable medium accessible by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive. The computer-readable storage medium may be a volatile or non-volatile storage medium, or may include two types of storage media: a volatile storage medium and a non-volatile storage medium.

In embodiments of this application, unless otherwise specified or logically conflicted, terms and/or descriptions in different embodiments are consistent and may be mutually referenced, and technical features in different embodiments may be combined based on an internal logical relationship thereof, to form a new embodiment.

In this application, "at least one" means one or more, and "a plurality of" means two or more. "And/or" describes an association relationship between associated objects, and indicates that three relationships may exist. For example, A and/or B may indicate the following cases: Only A exists, both A and B exist, and only B exists, where A and B may be singular or plural. In the text descriptions of this application, the character "/" generally indicates an "or" relationship between the associated objects; and in the formula in this application, the character "/" indicates a "division" relationship between the associated objects.

It may be understood that various numbers in embodiments of this application are merely used for distinguishing for ease of description, and are not used to limit the scope of embodiments of this application. Sequence numbers of the foregoing processes do not mean an execution sequence, and the execution sequence of the processes should be determined based on functions and internal logic of the processes.

## Claims

1. A data transmission method, applied to a first apparatus, wherein the method comprises:
determining compressed data based on N data blocks corresponding to an artificial intelligence AI model, wherein a compression scheme corresponding to each of the N data blocks is related to a distribution feature of the data block, the compressed data comprises M compressed blocks, the M compressed blocks are in one-to-one correspondence with M data blocks in the N data blocks, N is an integer greater than 1, and M is an integer not greater than N; and
sending the compressed data to a second apparatus.

2. The method according to claim 1, wherein the M compressed blocks comprise at least one first data block, and the first data block is a data block in the N data blocks.

3. The method according to claim 2, wherein an importance degree of the first data block is greater than a first threshold.

4. The method according to any one of claims 1 to 3, wherein the N data blocks comprise at least one second data block, and the second data block does not correspond to the M compressed blocks.

5. The method according to claim 4, wherein the second data block is weight data, and a change degree of the second data block is lower than a second threshold; or
the second data block is gradient data, and a probability that the second data block is within a stable interval is greater than a third threshold.

6. The method according to any one of claims 1 to 5, wherein the method further comprises: sending a compression parameter to the second apparatus, wherein the compression parameter indicates one or more of the following information: a model parameter of the AI model, a compression granularity of each of the N data blocks, or a compression scheme corresponding to each of the N data blocks; and the model parameter comprises at least one of the following: a type of the AI model, a quantity of layers of the AI model, a quantity of nodes at each layer of the AI model, or a function of each layer of the AI model.

7. The method according to claim 6, wherein the compression granularity of each of the N data blocks is a part of nodes at a layer, one layer, or a plurality of layers of the AI model.

8. The method according to any one of claims 1 to 7, wherein the M data blocks comprise at least one third data block, the third data block comprises one sub-data block or a plurality of sub-data blocks, and a difference degree between distribution information of any two of the plurality of the sub-data blocks is less than a fourth threshold.

9. A data transmission method, applied to a second apparatus, wherein the method comprises:
receiving compressed data from a first apparatus, wherein the compressed data comprises M compressed blocks, the M compressed blocks are in one-to-one correspondence with M data blocks in N data blocks corresponding to an artificial intelligence AI model, a compression scheme corresponding to each of the N data blocks is related to a distribution feature of the data block, N is an integer greater than 1, and M is an integer not greater than N; and
determining the AI model based on the compressed data.

10. The method according to claim 9, wherein the M compressed blocks comprise at least one first data block, and the first data block is a data block in the N data blocks.

11. The method according to claim 10, wherein an importance degree of the first data block is greater than a first threshold.

12. The method according to any one of claims 9 to 11, wherein the N data blocks comprise at least one second data block, and the second data block does not correspond to the M compressed blocks.

13. The method according to claim 12, wherein the second data block is weight data, and a change degree of the second data block is lower than a second threshold; or
the second data block is gradient data, and a probability that the second data block is within a stable interval is greater than a third threshold.

14. The method according to any one of claims 9 to 13, wherein the method further comprises:
receiving a compression parameter from the first apparatus; and
determining the AI model based on the compressed data comprises:
determining the AI model based on the compressed data and the compression parameter, wherein
the compression parameter indicates one or more of the following information: a model parameter of the AI model, a compression granularity of each of the N data blocks, or a compression scheme corresponding to each of the N data blocks; and the model parameter comprises at least one of the following: a type of the AI model, a quantity of layers of the AI model, a quantity of nodes at each layer of the AI model, or a function of each layer of the AI model.

15. The method according to claim 14, wherein the compression granularity of each of the N data blocks is a part of nodes at a layer, one layer, or a plurality of layers of the AI model.

16. The method according to any one of claims 9 to 15, wherein the M data blocks comprise at least one third data block, the third data block comprises one sub-data block or a plurality of sub-data blocks, and a difference degree between distribution information of any two of the plurality of the sub-data blocks is less than a fourth threshold.

17. A communication apparatus, comprising:
a processing unit, configured to determine compressed data based on N data blocks corresponding to an artificial intelligence AI model, wherein a compression scheme corresponding to each of the N data blocks is related to a distribution feature of the data block, the compressed data comprises M compressed blocks, the M compressed blocks are in one-to-one correspondence with M data blocks in the N data blocks, N is an integer greater than 1, and M is an integer not greater than N; and
a transceiver unit, configured to send the compressed data to a second apparatus.

18. The apparatus according to claim 17, wherein the M compressed blocks comprise at least one first data block, and the first data block is a data block in the N data blocks.

19. The apparatus according to claim 18, wherein an importance degree of the first data block is greater than a first threshold.

20. The apparatus according to any one of claims 17 to 19, wherein the N data blocks comprise at least one second data block, and the second data block does not correspond to the M compressed blocks.

21. The apparatus according to claim 20, wherein the second data block is weight data, and a change degree of the second data block is lower than a second threshold; or
the second data block is gradient data, and a probability that the second data block is within a stable interval is greater than a third threshold.

22. The apparatus according to any one of claims 17 to 21, wherein the transceiver unit is further configured to send a compression parameter to the second apparatus, wherein
the compression parameter indicates one or more of the following information: a model parameter of the AI model, a compression granularity of each of the N data blocks, or a compression scheme corresponding to each of the N data blocks; and the model parameter comprises at least one of the following: a type of the AI model, a quantity of layers of the AI model, a quantity of nodes at each layer of the AI model, or a function of each layer of the AI model.

23. The apparatus according to claim 22, wherein the compression granularity of each of the N data blocks is a part of nodes at a layer, one layer, or a plurality of layers of the AI model.

24. The apparatus according to any one of claims 17 to 23, wherein the M data blocks comprise at least one third data block, the third data block comprises one sub-data block or a plurality of sub-data blocks, and a difference degree between distribution information of any two of the plurality of the sub-data blocks is less than a fourth threshold.

25. A communication apparatus, comprising:
a transceiver unit, configured to receive compressed data from a first apparatus, wherein the compressed data comprises M compressed blocks, the M compressed blocks are in one-to-one correspondence with M data blocks in N data blocks corresponding to an artificial intelligence AI model, a compression scheme corresponding to each of the N data blocks is related to a distribution feature of the data block, N is an integer greater than 1, and M is an integer not greater than N; and
a processing unit, configured to determine the AI model based on the compressed data.

26. The apparatus according to claim 25, wherein the M compressed blocks comprise at least one first data block, and the first data block is a data block in the N data blocks.

27. The apparatus according to claim 26, wherein an importance degree of the first data block is greater than a first threshold.

28. The apparatus according to any one of claims 25 to 27, wherein the N data blocks comprise at least one second data block, and the second data block does not correspond to the M compressed blocks.

29. The apparatus according to claim 28, wherein the second data block is weight data, and a change degree of the second data block is lower than a second threshold; or
the second data block is gradient data, and a probability that the second data block is within a stable interval is greater than a third threshold.

30. The apparatus according to any one of claims 25 to 29, wherein the transceiver unit is further configured to receive a compression parameter from the first apparatus; and
that the processing unit is configured to determine the AI model based on the compressed data specifically comprises:
determining the AI model based on the compressed data and the compression parameter, wherein
the compression parameter indicates one or more of the following information: a model parameter of the AI model, a compression granularity of each of the N data blocks, or a compression scheme corresponding to each of the N data blocks; and the model parameter comprises at least one of the following: a type of the AI model, a quantity of layers of the AI model, a quantity of nodes at each layer of the AI model, or a function of each layer of the AI model.

31. The apparatus according to claim 30, wherein the compression granularity of each of the N data blocks is a part of nodes at a layer, one layer, or a plurality of layers of the AI model.

32. The apparatus according to any one of claims 25 to 31, wherein the M data blocks comprise at least one third data block, the third data block comprises one sub-data block or a plurality of sub-data blocks, and a difference degree between distribution information of any two of the plurality of the sub-data blocks is less than a fourth threshold.

33. A communication apparatus, comprising:
at least one processor, configured to enable the communication apparatus to perform the data transmission method according to any one of claims 1 to 8 or perform the data transmission method according to any one of claims 9 to 16 in at least one of the following manners: running computer instructions or a program or using a logic circuit.

34. A communication system, comprising a first apparatus configured to perform the method according to any one of claims 1 to 8, and a second apparatus configured to perform the method according to any one of claims 9 to 16.

35. A computer-readable storage medium, wherein the storage medium stores a computer program or instructions, and when the computer program or the instructions are executed by a communication apparatus, the method according to any one of claims 1 to 8 is implemented, or the method according to any one of claims 9 to 16 is implemented.

36. A computer program product, wherein the computer program product comprises a computer program or instructions, and when the computer program or the instructions are run on a processor, the processor is enabled to perform the method according to any one of claims 1 to 8, or perform the method according to any one of claims 9 to 16.
